**Europäisches Patentamt**

**European Patent Office**

**Office européen des brevets**

(19)

(11) Veröffentlichungsnummer: **0 100 432**

**A2**

(12)

# EUROPÄISCHE PATENTANMELDUNG

(21) Anmeldenummer: 83106291.4

(22) Anmeldetag: 28.06.83

(51) Int. Cl.³: **G 11 C 11/24**

(30) Priorität: 09.07.82 DE 3225803

(43) Veröffentlichungstag der Anmeldung:
15.02.84 Patentblatt 84/7

(84) Benannte Vertragsstaaten:
AT DE FR GB IT

(71) Anmelder: SIEMENS AKTIENGESELLSCHAFT
Berlin und München Wittelsbacherplatz 2
D-8000 München 2(DE)

(72) Erfinder: Frieling, Focko, Dipl.-Ing.
Putzbrunner Strasse 136
D-8012 Ottobrunn(DE)

(72) Erfinder: Michael, Ewald, Dipl.-Phys.
Jagdfeldring 87
D-8013 Haar(DE)

(54) **Signal-Pegelwandler.**

(57) Die Erfindung hat die Aufgabe, einen - insbesondere als Adreßpuffer für schnelle dynamische RAM-Speicher geeigneten - Signal-Pegelwandler anzugeben, der mit einem Minimum an Verzögerungszeit arbeitet und in MOS-Technik mit Feldeffekttransistoren vom selben Typ ausgeführt ist. Die erfindungsgemäße Schaltung für einen Signal-Pegelwandler ist so ausgelegt, daß sie mittels eines Differenzverstärkers ein die Abweichung des Wirkungspegels des den Wandler steuernden externen Digitalsignals vom Wirkungspegel der intern in der über den Signal-Pegelwandler zu beaufschlagenden integrierten Halbleiterschaltung laufenden Digitalsignale angebendes Differenzsignal bildet und dieses zur Steuerung eines dynamisch betriebenen und mit zwei Signalausgängen versehenen Ausgangsschaltungsteils verwendet. Der Ausgangsschaltungsteil des Signal-Pegelwandlers besteht aus zwei am Bezugspotential liegenden RS-Flip-Flops sowie aus zwei MOS-Feldeffekttransistoren, deren Sourceanschlüsse je einen der beiden Signalausgänge bilden und mit dem nichtinvertierenden Ausgang je eines der beiden RS-Flip-Flops verbunden sind. Die Drainanschlüsse der beiden MOS-Feldeffekttransistoren werden gemeinsam durch ein Hilfssignal getaktet, während die Beaufschlagung der Ausgangsschaltung von seiten des Differenzverstärkers über die Gates der beiden MOS-Feld-effekttransistoren erfolgt.

FIG 1

0100432

Siemens Aktiengesellschaft          Unser Zeichen
Berlin und München                  VPA  82 P 1530 E

Signal-Pegelwandler

Die Erfindung befaßt sich mit einem Signal-Pegelwandler für die Steuerung digitaler MOS-Schaltkreise, insbesondere einer Adreßpufferschaltung für dynamische
MOS-Speicher, bei der der - ebenfalls in MOS-Technik
ausgestaltete und integrierbare - Signal-Pegelwandler
einerseits durch ein erstes und ein - als Bezugspotential geschaltetes - zweites Versorgungspotential und
andererseits an einem Signaleingang durch das zu verarbeitende digitale Steuersignal beaufschlagt ist,
und bei der außerdem kreuzgekoppelte Feldeffekttransistorpaare sowie zwei - zu einander invertierte Signale
führende - Ausgangsanschlüsse für die Steuerung eines
digitalen Schaltkreises vorgesehen sind.

Signal-Pegelwandler werden bekanntlich häufig dann bei
digitalen integrierten Halbleiterschaltungen verwendet,
wenn ein von einer in einer ersten Technologie hergestellten digitalen Halbleiterschaltung geliefertes
Digitalsignal zur Steuerung einer in einer zweiten Technologie hergestellten zweiten digitalen Schaltung verwendet und deshalb eine Pegelanpassung der zu steuernden Digitalsignale an die für die Beaufschlagung der
zweiten Schaltung erforderlichen Impulse notwendig ist.
Vor allem werden Signal-Pegelwandler als Adreßpuffer
für MOS-Schreib-Lesespeicher verwendet, wobei das von
einer externen Steuerquelle, z.B. von einer Schaltung
in ECL-Technik, zur Verfügung gestellte Adressiersignal hinsichtlich seines Pegels auf das für MOS-Halbleiterspeicher erforderliche Niveau abgeändert werden muß.

Im allgemeinen geschieht die Pegelwandlung unter Kontrolle von Steuerimpulsen. Dabei ist darauf zu achten,
daß erst nach Abschluß der Pegelwandlung weitere digitale Vorgänge, z.B. im Falle des Adreßpuffers die Wortleitungsauswahl, in Angriff genommen werden, da sonst eine Signalfälschung, z.B. in dem angedeuteten Fall eine Fehladressierung, die Folge wäre. Da man aber andererseits aus bekannten Gründen daran interessiert ist, daß die Adressierung möglichst rasch abläuft, gilt dasselbe auch für die Funktion eines Pegelwandlers.

Ein in MOS-Technik integrierter Adreßpuffer ist in "IEEE-Journal of Solid-State Circuits" Vol. SC-15, No. 5 (Oct. 1980) auf Seite 843 im Schaltbild dargestellt (vgl. Fig. 9). Dabei ist jedoch festzustellen, daß das bei dem bekannten Adreßpuffer verwendete und ebenfalls der eingangs gegebenen Definition entsprechende Schaltungsprinzip die zur Steuerung des dem Adreßpuffer nachgeschalteten Teils des Speichers (d.h. also eines internen Dekdierers) benötigten Sekundärsignale nur mit einer verhältnismäßig hohen Verzögerung liefert, weil zum Betrieb der Schaltung ein verhältnismäßig großer Impulsaufwand erforderlich ist.

Wie nun gemäß der Erfindung erkannt wurde, ist es bei einer geeigneten Ausgestaltung eines solchen Adreßpuffers durchaus möglich, die minimale Ansprechzeit um 5 bis 6 ns zu vermindern, weil eine solche Ausgestaltung eine Impulssorte weniger als die bekannte Schaltung zum einwandfreien Funktionieren braucht, und deshalb die zur Erzeugung dieser Impulssorte bedingte Ansprechverzögerung zum Fortfall kommt. Die Erfindung hat sich die Aufgabe gestellt, eine solche Schaltung für einen Signal-Pegelwandler anzugeben, die somit im Vergleich zu den bekannten Adreß-Pegelwandlern zu einer merklichen Reduktion der minimalen Verzögerungsspanne führt und die zu ihrer Realisierung lediglich einfache MOS-Feldeffekttransistoren vomselben Kanaltyp, insbesondere selbstsperrende MOS-FET's benötigt.

Zur Lösung dieser Aufgabe ist gemäß der Erfindung ein Signal-Pegelwandler derart ausgebildet, daß der Signaleingang für das digitale Steuersignal durch das Gate eines ersten Feldeffekttransistors gegeben und dessen Source mit der Source eines zweiten Feldeffekttransistors sowie mit dem Drain eines dritten Feldeffekttransistors verbunden ist, daß dabei der dritte Feldeffekttransistor an seiner Source durch ein erstes Hilfssignal gesteuert, der Drain des ersten Feldeffekttransistors über einen vierten Feldeffekttransistor sowie der Drain des zweiten Feldeffekttransistors über einen fünften Feldeffekttransistor mit je einem der beiden stromführenden Anschlüsse eines sechsten Feldeffekttransistors verbunden ist, daß außerdem der eine stromführende Anschluß des sechsten Feldeffekttransistors mit der Source eines siebenten Feldeffekttransistors und dem Gate eines achten Feldeffekttransistors und der andere stromführende Anschluß des sechsten Feldeffekttransistors mit der Source des achten Feldeffekttransistors und dem Gate des siebenten Feldeffekttransistors und der Drain des siebenten und des achten Feldeffekttransistors über die Reihenschaltung eines neunten Feldeffekttransistors und eines zehnten Feldeffekttransistors miteinander verbunden sind, daß außerdem die Source des siebenten Feldeffekttransistors über die Source-Drainstrecke eines elften Feldeffekttransistors und eines zum elften Feldeffekttransistor parallel liegenden zwölften Feldeffekttransistors sowie die Source des achten Feldeffekttransistors über einen dreizehnten Feldeffekttransistor und einen zu diesem parallel liegenden vierzehnten Feldeffekttransistor an das erste Versorgungspotential angeschlossen und dabei das Gate des elften Feldeffekttransistors mit dem Drain des siebenten Feldeffekttransistors sowie das Gate des dreizehnten Feldeffekttransistors mit dem Drain des achten Feldeffekttransistors verbunden ist, daß weiterhin ein Knoten zwischen dem neunten Feldeffekttransistor und dem zehnten Feldeffekttransistor über einen fünfzehnten Feldeffekttransistor mit dem ersten Versorgungspotential verbunden und das Gate des fünfzehnten Feldeffekttransistors zusammen mit dem Gate des sechsten Feldeffekttransistors, des neunten Feldeffekttransistors, des zehnten Feldeffekttransistors, des zwölften Feldeffekttransistors sowie des vierzehnten Feldeffekttransistors durch ein zweites Hilfssignal gemeinsam gesteuert sind, während das Gate des zweiten Feldeffekttransistors, des dritten Feldeffekttransistors, des vierten Feldeffekttransistors und des fünften Feldeffekttransistors gemeinsam durch ein zwischen den beiden Versorgungspotentialen liegendes Hilfspotential beaufschlagt sind, daß ferner ein sechzehnter Feldeffekttransistor zusammen mit einem siebenzehnten Feldeffekttransistor zu einem ersten RS-Flip-Flop sowie ein achtzehnter Feldeffekttransistor zusammen mit einem neunzehnten Feldeffekttransistor zu einem zweiten RS-Flip-Flop zusammengeschaltet ist, wobei die Sourceanschlüsse der beteiligten Feldeffekttransistoren am Bezugspotential liegen, während der Drain des sechzehnten Feldeffekttransistors mit der Source des siebenten Feldeffekttransistors sowie der Drain des achtzehnten Feldeffekttransistors mit der Source des achten Feldeffekttransistors verbunden ist, während der Drain des siebenzehnten Feldeffekttransistors mit der Source eines zwanzigsten Feldeffekttransistors und der Drain des neunzehnten Feldeffekttransistors mit der Source eines einundzwanzigsten Feldeffekttransistors verbunden und dabei das Gate des zwanzigsten Feldeffekttransistors durch den Drain des achten Feldeffekttransistors sowie das Gate des einundzwanzigsten Feldeffekttransistors durch den Drain des siebenten Feldeffekttransistors gesteuert ist, während die Drainanschlüsse des zwanzigsten und des einundzwanzigsten Feldeffekttransistors durch ein gemeinsames drittes Hilfssignal gesteuert sind, und daß schließlich die von einem gemeinsamen Taktgeber gelieferten Hilfssignale derart aufeinander abgestimmt sind, daß der Wirkungspegel des ersten Hilfssignals sowie des zweiten Hilfssignals praktisch gleichzeitig gegeben und der Wirkungspegel des zweiten Hilfssignals merklich höher als der Wirkungspegel des ersten Hilfssignals eingestellt ist, während das etwa denselben Wirkungspegel wie das zweite Hilfssignal aufweisende dritte Hilfssignal unmittelbar mit dem Abklingen des ersten Hilfssignals einsetzt, und daß außerdem der Nullzustand der drei Hilfssignale durch das Bezugspotential gegeben und der Sourceanschluß des zwanzigsten sowie des einundzwanzigsten Feldeffekttransistors als je ein Signalausgang des Signal-Pegelwandlers verwendet ist.

Die Erfindung wird nun anhand der Zeichnungen näher beschrieben. Dabei ist in Figur 1 die der soeben gegebenen Definition der Erfindung entsprechend Schaltung in Ein-Kanal-MOS-Technik mit selbstsperrenden MOS-FET's dargestellt, während in Figur 2 das zugehörige Zeitdiagramm gezeigt ist. Figur 3 bringt eine Ergänzung für den Signalausgang des erfindungsgemäßen Signal-Pegelwandlers, der dann die Verbindung zwischen der oben definierten Schaltung und dem Signaleingang des durch den Signal-Pegelwandler zu beaufschlagenden Schaltungsteiles bildet, der zweckmäßig mit dem erfindungsgemäßen Signal-Pegelwandler monolithisch zusammengefaßt wird. Figur 4 zeigt eine Ausgestaltung für den der Erzeugung der drei Hilfssignale dienenden Taktgeber.

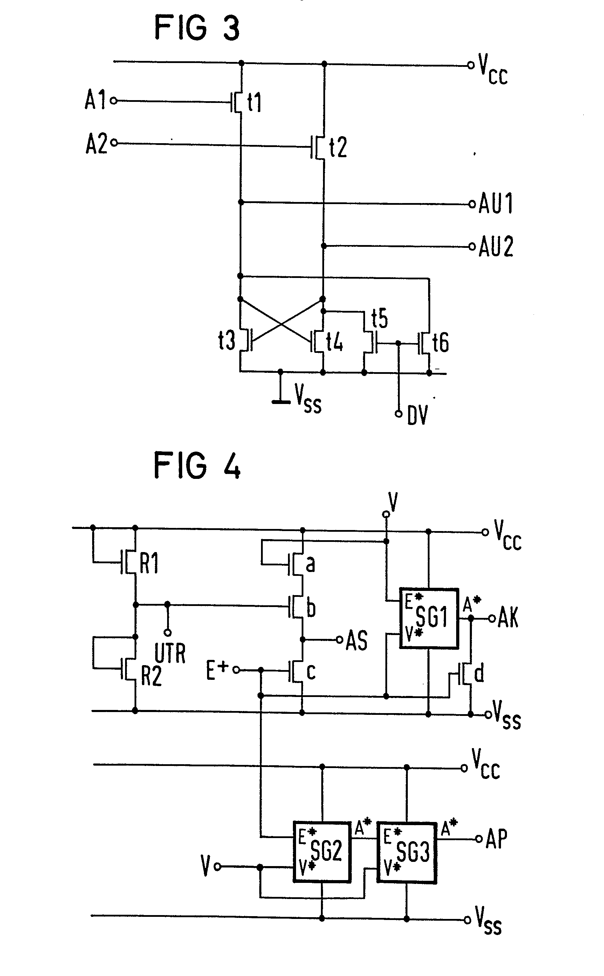

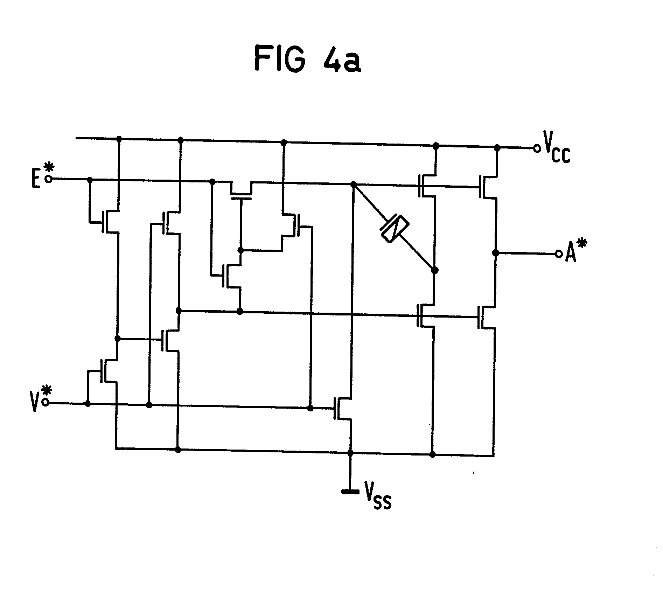

Der mit den bezüglich ihres Pegels zu wandelnden Steuersignalen zu beaufschlagende Signaleingang E ist durch das Gate eines ersten Feldeffekttransistors T1 gegeben. Der Sourceanschluß dieses ersten Feldeffekttransistors T1 ist mit dem Sourceanschluß eines zweiten - gleichen - Feldeffekttransistors T2 und außerdem mit dem Drain eines dritten Feldeffekttransistors T3 verbunden. Die Source des dritten Feldeffekttransistors T3 wird vom Taktgeber TG mit den das erste Hilfssignal AS bildenden Impulsen beaufschlagt, während sein Gate mit dem z.B. mittels eines Spannungsteilers R1, R2 (vgl. Figur 4) von den beiden Versorgungspotentialen $V_{cc}$ und $V_{ss}$ abgeleiteten Hilfs-

potentials UTR beaufschlagt ist. Das erste Versorgungspotential ist wie üblich mit $V_{cc}$ und das als Bezugspotential (Masse) geschaltete zweite Versorgungspotential mit $V_{ss}$ bezeichnet.

Der Drain des ersten Feldeffekttransistors T1 liegt an der Source eines vierten Feldeffekttransistors T4 und der Drain des zweiten Feldeffekttransistors T2 an der Source eines fünften Feldeffekttransistors T5. Zur Beaufschlagung des Gates des zweiten Feldeffekttransistors T2, des vierten Feldeffekttransistors T4 sowie des fünften Feldeffekttransistors T5 dient dasselbe Hilfspotential UTR, das zur Steuerung des Gates des dritten Feldeffekttransistors T3 vorgesehen ist.

Der Drain des vierten Feldeffekttransistors T4 ist mit dem Drain des fünften Feldeffekttransistors T5 über die stromführende Strecke eines sechsten Feldeffekttransistors T6 verbunden, dessen Gate durch das zweite Hilfssignal AK gesteuert ist. Außerdem führt der Drain des vierten Feldeffekttransistors T4 zu einem Schaltungsknoten, der durch den Sourceanschluß eines siebenten Feldeffekttransistors T7, dem Gate eines achten Feldeffekttransistors T8, dem Sourceanschluß eines elften Feldeffekttransistors T11 sowie dem Sourceanschluß eines zwölften Feldeffekttransistors T12 gebildet ist. In entsprechender Weise führt der Drain des fünften Feldeffekttransistors T5 zu einem Schaltungsknoten, der durch den Sourceanschluß des achten Feldeffekttransistors T8, dem Gate des siebenten Feldeffekttransistors T7 sowie dem Sourceanschluß eines dreizehnten Feldeffekttransistors T13 und eines vierzehnten Feldeffekttransistors T14 gebildet ist.

Zu erwähnen ist, daß die besagten Schaltungsknoten außerdem in noch zu beschreibender Weise an das in der Definition der Erfindung genannten erste RS-Flip-Flop bzw. an das zweite RS-Flip-Flop angeschlossen sind.

Der Drain des siebenten Feldeffekttransistors T7 und der Drain des achten Feldeffekttransistors T8 sind über die hintereinander geschalteten Source-Drainstrecken eines neunten Feldeffekttransistors T9 und eines zehnten Feldeffekttransistors T10, deren Gates - ebenso wie der Transistor T6 - durch das zweite Hilfssignal AK gesteuert sind. Ein zwischen dem neunten Feldeffekttransistor T9 und dem zehnten Feldeffekttransistor T10 liegender Schaltungspunkt ist über einen fünfzehnten Feldeffekttransistor T15 mit dem ersten Versorgungspotential $V_{cc}$ verbunden, an welchem außerdem die Drains des elften Feldeffekttransistors T11, des zwölften Feldeffekttransistors T12, des dreizehnten Feldeffekttransistors T13 sowie des vierzehnten Feldeffekttransistors T14 liegen.

Weiterhin ist festzustellen, daß das Gate des elften Feldeffekttransistors T11 mit dem Drain des siebenten Feldeffekttransistors T7 und das Gate des dreizehnten Feldeffekttransistors T13 mit dem Drain des achten Feldeffekttransistors T8 verbunden ist. Im Gegensatz hierzu liegt das Gate des zwölften Feldeffekttransistors T12, des vierzehnten Feldeffekttransistors T14 und des fünfzehnten Feldeffekttransistors T15 am zweiten Hilfssignal AK.

Wie bereits angedeutet ist der Sourceanschluß des siebenten Feldeffekttransistors T7 neben den bereits angegebenen Verbindungen zu den Transistoren T4, T6, T8, T11 und T12 mit dem Drain eines sechzehnten Feldeffekttransistors T16 und dem Gate eines siebenzehnten Feldeffekttransistors T17 verbunden. Ebenso ist neben den bereits genannten Verbindungen zu T5, T6, T13 und T14 für den Sourceanschluß des achten Feldeffekttransistors T8 noch eine Verbindung zum Drain eines achtzehnten Feldeffekttransistors T18 und dem Gate eines neunzehnten Feldeffekttransistors T19 vorgesehen.

Die zuletzt eingeführten Feldeffekttransistoren T16 bis T19 liegen mit ihren Sourceanschlüssen am Bezugspotential $V_{ss}$. Die beiden Transistoren T16 und T17 bilden somit ein erstes RS-Flip-Flop und die beiden Transistoren T18 und T19 ein zweites RS-Flip-Flop.

Ferner ist der Drain des siebenten Feldeffekttransistors T7 sowie der Drain des achten Feldeffekttransistors T8 zur Steuerung des Gates je eines weiteren Feldeffekttransistors T20 bzw. T21 vorgesehen, deren Drainanschlüsse gemeinsam durch das in der Definition der Erfindung erwähnte dritte Hilfssignal AP beaufschlagt sind. Ferner liegt der mit dem Drain des achten Feldeffekttransistors T8 verbundene zwanzigste Feldeffekttransistor T20 mit seiner Source am Gate des sechzehnten Feldeffekttransistors und am Drain des siebenzehnten Feldeffekttransistors T17. In entsprechender Weise ist die Source des mittels des Drains des siebenten Feldeffekttransistors T7 an seinem Gate gesteuerten einundzwanzigsten Feldeffekttransistors T21 mit dem Drain des neunzehnten Feldeffekttransistors T19 und dem Gate des achtzehnten Feldeffekttransistors T18 leitend verbunden.

Zur Erzeugung des im Zusammenhang mit den Feldeffekttransistoren T2, T3, T4 und T5 genannten Hilfspotentials UTR kann, wie bereits bemerkt, ein Spannungsteiler R1,R2 verwendet werden, der in Verbindung mit in Figur 4 im Detail dargestellten Taktgeber TG dargestellt und auf der einen Seite durch das erste Versorgungspotential $V_{cc}$ und auf der anderen Seite durch das als Bezugspotential für die gesamte Schaltung vorgesehene zweite Versorgungspotential $V_{ss}$ beaufschlagt ist. Vorzugsweise wird das zwischen den beiden Versorgungspotentialen liegende Hilfspotential UTR so eingestellt, daß es in der Mitte zwischen den beiden die logischen Pegel definierenden Potentialwerten liegt.

Der Sourceanschluß des zwanzigsten Feldeffekttransistors
T20 sowie der Sourceanschluß des einundzwanzigsten Feldeffekttransistors T21 bzw. der mit dem betreffenden Sourceanschluß jeweils verbundene Ausgang der durch T16 und T17
bzw. T18 und T19 gebildeten RS-Flip-Flops bilden je einen
Signalausgang A1 bzw. A2 des Signal-Pegelwandlers.

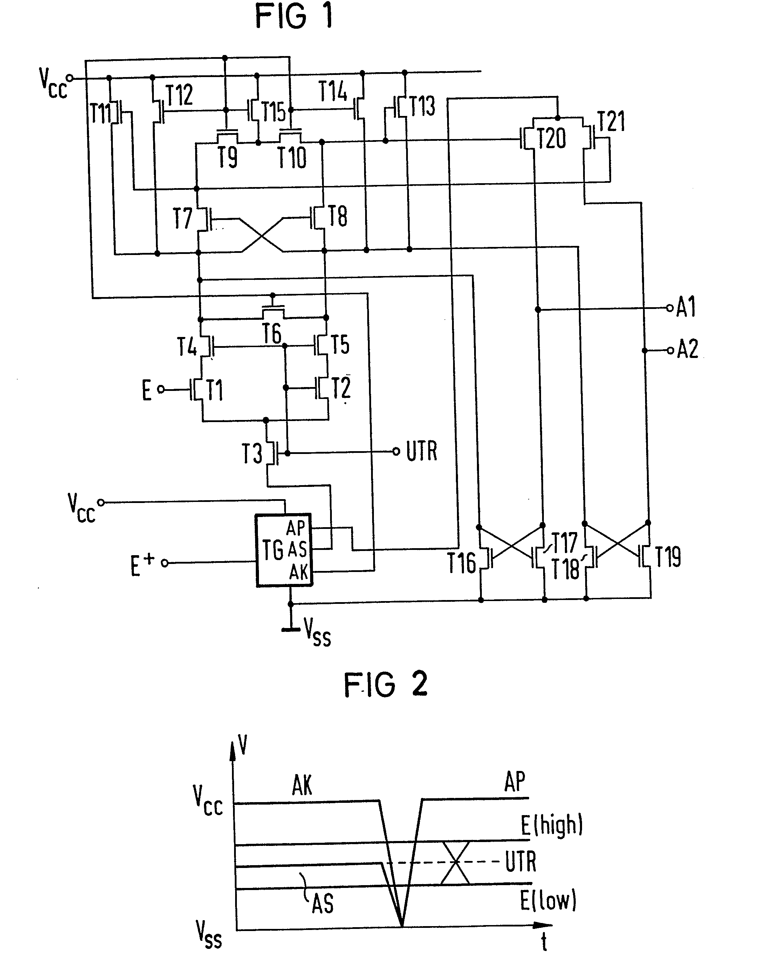

Der zeitliche Verlauf der beiden Hilfssignale AS und AK
sowie des weiteren Hilfssignals AP ist in Figur 2 dargestellt und entspricht ebenfalls der Definition der Erfindung.

Der in Figur 3 gezeigten Ergänzungsteil wird z.B. vorteilhafterweise dann verwendet, wenn die in Figur 1 dargestellte Anlage gemäß der Erfindung als Adreßpufferschaltung für
einen dynamischen MOS-Speicher eingesetzt werden soll. Dieser Ergänzungsschaltung zufolge wird der Ausgang A1, also
die Source des zwanzigsten Feldeffekttransistors (bzw.
der Drain von T17 und das Gate von T16 und damit das von
der Source des siebenten Feldeffekttransistors T7 gesetzte RS-Flip-Flop) zur Steuerung des Gates des ersten Feldeffekttransistors t1 der in Figur 3 gezeigten Nachschaltung vorgesehen. Der andere Ausgang A2 der in Figur 1 gezeigten Schaltung (also die Source des 21.Feldeffekttransistors T21 und damit der Ausgang des T18 und T19 gebildeten zweiten RS-Flip-Flops) dienen zur Steuerung des
Gates des zweiten Feldeffekttransistors t2 der in Fig.3
gezeigten Nachschaltung. Sowohl der erste Transistor t1
als auch der zweite Transistor t2 liegen mit ihrem Drain
am ersten Versorgungspotential $V_{cc}$. Die Source des ersten
Feldeffekttransistors t1 ist einerseits mit dem Drain eines Feldeffekttransistors t3 und dem Gate eines vierten
Feldeffekttransistors t4 in der Nachschaltung verbunden.
Andererseits liegt die Source des zweiten Feldeffekttransistors t2 der Nachschaltung am Gate des dritten Feldeffekttransistors t3 sowie am Drain des vierten Feldeffekttransistors t4. Beide Feldeffekttransistoren t3 und t4 sind über ihre Sourceelektrode mit dem Bezugspotential $V_{ss}$ verbunden. Beide Feldeffekttransistoren t3 und t4 bilden also ebenfalls ein RS-Flip-Flop. Dabei ist die Source-Drainstrecke der beiden das Flip-Flop bildenden Feldeffekttransistoren t3 und t4 durch die Source-Drainstrecke jeweils eines weiteren Feldeffekttransistors t5 bzw. t6 überbrückt, die durch ein gemeinsames viertes Hilfssignal DV gesteuert sind. Die beiden Signalausgänge AU1 und AU2 sind durch den Sourceanschluß des ersten Transistors t1 bzw. des zweiten Transistors t2 gegeben.

Um nun eine maximale Reaktionsgeschwindigkeit auf das an den Signaleingang E des in Figur 1 dargestellten Pegelwandlers (und an die Klemme für das Bezugspotential $V_{ss}$) zu legende Eingangssignal (d.h. auf den Wirkungspegel dieses Signals) zu erreichen, ist es vorteilhaft, wenn der Wirkungspegel des ersten Hilfssignals AS gleich dem zur Steuerung der Gates der Feldeffekttransistoren T2 - T5 vorgesehenen Hilfspotential UTR eingestellt wird, weil in diesem Fall eine sofortige Bewertung des an den Eingang E gelegten Pegels des externen Signals bewirkt wird.

Bei der aus Figur 1 ersichtlichen und der Definition der Erfindung entsprechenden MOS-Schaltung ergibt sich nun folgendes Verhalten: Der zwischen T7 und T9 liegende Schaltungsknoten sowie der zwischen T8 und T10 liegende Schaltungsknoten wird durch die Transistoren T11, T13 und T6 bzw. durch die Transistoren T9, T10 und T15 symmetrisch auf das Potential $(V_{cc} - U_T)$ gebracht $(U_T =$ Schwellspannung). Die Transistoren T1, T2 und T3 bilden zusammen einen Differenzverstärker, der durch das erste Hilfssignal AS aktiviert wird.

Die Feldeffekttransistoren T4 und T5 haben die Aufgabe, "Bump-Probleme", d.h. Störungen, die durch Änderungen des ersten Versorgungspotentials $V_{cc}$ und damit der Versorgungsspannung bedingt sind, zu unterdrücken. Über die Transistoren T3 bzw. T1 und T2 sind beim Leitendwerden von T1 die Drains von T1, T2 und T3 auf den Wirkungspegel des ersten Hilfssignals AS und bei Beachtung der oben angegebenen (vorzugsweise anzuwendenden) Bemessung dieses Pegels auf den Wert des Hilfspotentials UTR auf den Wert dieses Hilfspotentials UTR vorgeladen.

Je nach dem Niveau des am Signaleingang E anliegenden externen Signalpegels beginnt eine Seite des Differenzverstärkers T1, T2 und T3 früher als die andere Seite Strom zu ziehen, wodurch entweder die Source von T7 oder die Source des mit T7 kreuzgekoppelten Feldeffekttransistors T8 in Richtung auf das Bezugspotential $V_{ss}$ gezogen wird. Um über einen längeren Zeitraum das unsymmetrische Stromziehen des Differenzverstärkers T1, T2 und T3 zu ermöglichen, liefert der Transistor T15 bzw. der Transistor T11 den erforderlichen Strom an den Differenzverstärker. Die Stärke dieses Stroms wird durch die als Stromschalter wirkenden kreuzgekoppelten Feldeffekttransistoren T7 und T8 auf derjenigen Seite des Differenzverstärkers T1, T2, T3 veringert, die in Abhängigkeit von dem am Eingang E anhängigen externen Steuersignal in Richtung auf das Bezugspotential $V_{ss}$ gezogen werden soll.

Bevor nun das dritte das dritte Hilfssignal AP einsetzt, stellen die Knoten an den Sourceanschlüssen von T7 und T8 eine Unsymmetrie an den Signalausgängen A1 und A2 unter Vermittlung der Flip-Flops T16 und T17 bzw. T18 und T19 her. Somit wird sowohl an den Gates von T20 und T21 als auch an den Signalausgängen A1 und A2 eine Unsymmetrie herbeigeführt. Die positive (ansteigende) Flanke des dritten Hilfssignals AP wirkt am Signalausgang A1 einerseits dadurch, weil sich die Sourceanschlüsse von T7 und T8 dank der Unsymmetrie im Verhalten des Differenzverstärkers T1, T2, T3 sich auf unterschiedlichem Potential befinden und demnach der Ladezustand an den mit dem Sourceanschluß von T7 bzw. T8 über je ein RS-Flip-Flop T16/T17 bzw. T18/T19 in Verbindungstehenden Signalausgängen A1 bzw. A2 in unterschiedlichem Maße abgebaut wird. Anderseits wirkt die positive Flanke des dritten Hilfssignals AP sich am Signaleingang A1 bzw. A2 deswegen aus, weil die Gatespannnung von T20 und T21 aufgrund der besagten Unsymmetrie am Differenzverstärker T1,T2, T3 und damit an den kreuzgekoppelten Transistoren T7 und T8 in unterschiedlicher Weise eingestellt wird. Wegen der Bootstrapwirkung der Feldeffekttransistoren T20 und T21 wird der Ladezustand eines der beiden Signalausgänge A1 bzw. A2 auf das Potential des dritten Hilfssignals AP gezogen, während das Potential des anderen Signalausgangs auf den Nullpegel, also das Bezugspotential $V_{ss}$, gebracht wird. Über die Flip-Flops T16/T17 und T18/T19 werden die Sourceanschlüsse von T7 bzw. T8 auf ein praktisch am Bezugspotential $V_{ss}$ liegendes Niveau gezogen.

Die Veringerung der zwischen dem Einsetzen eines externen Steuerimpulses am Signaleingang E und dem am Ausgang A1 bzw. A2 in Antwort auf diesen Steuerimpuls erscheinenden Sekundärimpuls bedingten Zeitspanne bei der erfindungsgemäßen Anlage ist vor allem dem Umstand zu verdanken, daß diese Anlage im Vergleich zu den bekannten Signal-Pegelwandlern mit einem geringeren Aufwand an die Verzögerung bedingenden Hilfssignalen auskommt. Außerdem besitzt der erfindungsgemäße Signal-Pegelwandler günstigere Eigenschaften hinsichtlich Überschwingern oder Unterschwingern bei den an den Signaleingang gelegten Steuersignalen, wodurch eine größere Störsicherheit beim Betrieb der durch den Signal-Pegelwandler gesteuerten und zweckmäßig mit dem Pegelwandler monolithisch zusammengefaßten digitalen MOS-Schaltung erreicht wird.

Die in Figur 3 dargestellte Ergänzung des erfindungsgemäßen Signal-Pegelwandlers enthält die beiden als als Source-Folger betriebenen Feldeffekttransistoren t1 und t2, die im Falle der Verwendung des erfindungsgemäßen Signal-Pegelwandlers als Adreßpuffer in einer integrierten MOS-RAM-Speicherschaltung die für den zugehörigen internen Eingang des Adreßdekoders das erforderliche Adreßbit liefert. Jeder der vorgesehenen Eingänge des Adreßdekoders wird dann durch je einen Pegelwandler gemäß der Erfindung beaufschlagt.

Das in der Ergänzungsschaltung gemäß Figur 3 vorgesehene Flip-Flop t3/t4 dient zur Speicherung der Adresse, wenn der Pegel des dritten Hilfssignals AP wieder auf den Wert des zweiten Versorgungspotentials $V_{ss}$ abgesenkt wird. Die Transistoren t5 und t6 dienen zum Killen der Ladezustände an den Signalausgängen AU1 und AU2 des Ergänzungsteils nach Beendigung eines Speicherzyklus. Das hierzu vorgesehene Aktivierungssignal DV für die beiden Transistoren t5 und t6 ist zweckmäßig das vom Speicher zum Abschluß des jeweiligen Adressiervorgangs für die Rücksetzung der Adresse zur Verfügung gestellte Signal.

Ergänzend zu den bisherigen Ausführungen ist nochmals festzustellen, daß die in den Schaltungen gemäß Figur 1 und Figur 3 verwendeten Feldeffekttransistoren vomselben Typ und insbesondere als MOS-FET's vom Anreicherungstyp ausgebildet sind. Im Interesse der höheren Schaltgeschwindigkeit wird man in den meisten Fällen n-Kanal-Transistoren verwenden.

In Figur 4 ist eine MOS-Schaltung für den zur Erzeugung der Hilfssignale AS, AK und AP dienenden Taktgeber TG dargestellt, der außerdem, wie bereits bemerkt, den zur Erzeugung des Hilfspotentials UTR dienenden Spannungsteiler R1, R2 enthält. Zur Beaufschlagung des Taktgebers TG dient einerseits die durch die beiden Versorgungspotentiale $V_{cc}$ und $V_{ss}$ definierte Versorgungsspannung

während andererseits zwei Impulsfolgen E und V vorgesehen sind, wobei die Impulse der Folge V als Vorladeimpulse und die Impulse E, die an den Signaleingang $E^+$ gelegt sind, als Steuerimpulse dienen. Demzufolge sind in üblicher Weise die taktenden Steuerimpulse und die diesen jeweils zugeordneten Vorladeimpulse V derart aufeinander abgestimmt, daß die einzelnen Impulse in der Pause zwischen je zwei unmittelbar aufeinanderfolgenden Steuerimpulsen $E^+$ erscheinen.

Im Taktgeber TG ist zunächst eine Reihenschaltung von drei MOS-Feldeffekttransistoren a, b und c an die Versorgungsspannung der Anlage gelegt. Das Gate des dabei unmittelbar am ersten Versorgungspotential $V_{cc}$ liegenden Feldeffekttransistors a ist durch die Vorladeimpulse V, das Gate des mittleren Feldeffekttransistors b ist durch das Hilfspotential UTR und das Gate des am Bezugspotential $V_{ss}$ unmittelbar liegenden Feldeffekttransistors c ist durch die Steuerimpulse E beaufschlagt. Einschaltungspunkt zwischen dem mittleren dieser Feldeffekttransistoren, also dem Transistor b und dem am Bezugspotential $V_{ss}$ liegenden Feldeffekttransistor c liefert dann das erste Hilfssignal AS.

Der bereits im Zusammenhang mit dem Hilfspotential UTR oben erwähnte Spannungsteiler R1 und R2 liegt am einen Ende, d.h. dem als Widerstand geschalteten Transistor R1 am ersten Versorgungspotential $V_{cc}$ und mit dem anderen Ende, d.h. dem als Widerstand geschalteten Transistor R2 am Bezugspotential $V_{ss}$. Der zwischen den beiden Transistoren R1 und R2 liegende Teilerpunkt liefert das Hilfspotential UTR. Vorzugsweise sind die beiden Transistoren R1 und R2 des Spannungsteilers einander gleich, so daß sich das Hilfspotential UTR in der Mitte zwischen den beiden Versorgungspotentialen $V_{cc}$ und $V_{ss}$ befindet.

Die in Figur 4 dargestellte Anlage für einen Taktgeber TG weist außerdem drei einander gleiche Schaltungsteile SG1, SG2 und SG3 auf, wie er im Detail in Figur 4a dargestellt ist. Da es sich hierbei um eine übliche Schaltung (vgl. IEEE Journal of Solid-State Circuits, Vol. SC-15, No. 5, October 1980, S. 844 Figur 11b) handelt, kann von einem weiteren Eingehen auf diese Schaltung abgesehen werden. Diese drei Schaltungsteile SG;, SG2 und SG3 haben je einen Eingang $E^*$, einen Eingang $V^*$ und einen Signalausgang $A^*$.

Der erste dieser einander gleichen Schaltungsteile, d.h. der Schaltungsteil SG1 wird an seinem Eingang $E^*$ mit den Vorladeimpulsen V, an seinem Eingang $V^*$mit den Steuerimpulsen $E^+$ für den Taktgeber TG beaufschlagt, während sein Ausgang $A^*$ die zweite Folge AK von Hilfsignalen zur Verfügung stellt. Hierzu ist dieser Ausgang $A^*$ zusätzlich über die Source-Drainstrecke eines weiteren Feldeffekttransistors d, der an seinem Gate von den Steuerimpulsen $E^+$ für den Taktgeber TG beaufschlagt ist, mit dem Bezugspotential $V_{ss}$ verbunden. Der Feldeffekttransistor d wirkt somit als Ladungskiller.

Der zweite und der dritte dieser einander gleichen Schaltungsteile, also der Schaltungsteil SG2 und der Schaltungsteils SG3, dienen der Erzeugung der dritten Hilfssignale AP. Hierzu ist der Eingang $E^*$ des Schaltungsteils SG2 durch die Steuerimpulse $E^+$ für den Taktgeber TG beaufschlagt, während der andere Eingang, also der Eingang $V^*$ dieses Schaltungsteils SG2 mit den Vorladimpulsen V beaufschlagt ist. Der Ausgang $A^*$dieses Schaltungsteils SG2 liegt am Eingang $E^*$des dritten Schaltungsteils SG3, dessen anderer Eingang $V^*$mit den Steuersignalen $E^+$ für den Taktgeber TG gesteuert ist. Der Ausgang $A^*$ dieses dritten Schaltungsteils SG3 liefert dann das dritte Hilfssignal AP.

Die in der Schaltung gemäß Figur 4 bzw. 4a verwendeten Feldeffekttransistoren sind zweckmäßig vomselben Typ wie die übrigen in der Schaltung verwendeten Transistoren. Sie sind deshalb vorwiegend vom n-Kanaltyp und selbstsperrend. Die Widerstände R1 und R2 des Spannungsteilers können ggf. auch vom selbstleitenden Typ sein. Im Interesse der Vereinfachung der Herstellung wird man jedoch in vielen Fällen alle Transistoren vom gleichen Typ, also vom selbstsperrenden Typ wählen.

Zu bemerken ist außerdem, daß es ohne weiteres möglich ist, die für den Betrieb des erfindungsgemäßen Impuls-Pegelwandlers benötigten Hilfssignale auf eine andere Weise als mit einer Schaltung gemäß Figur 4 und 4a zu erzeugen.

4 Figuren
Patentansprüche

<u>Patentansprüche</u>

1.) Signal-Pegelwandler für die Steuerung digitaler MOS-Schaltkreise, insbesondere Adreßpufferschaltung für dynamische MOS-Speicher, der in integrierbarer Form in MOS-Technik ausgestaltet und einerseits durch ein erstes und ein - als Bezugspotential geschaltetes - zweites Versorgungspotential und andererseits an einem Signaleingang durch das zu verarbeitende digitale Steuersignal beaufschlagt ist, und bei dem außerdem kreuzgekoppelte Feldeffekttransistorpaare sowie zwei - zu einander invertierte Signale führende - Ausgangsanschlüsse für die Steuerung eines digitalen Schaltkreises vorgesehen sind, <u>dadurch gekennzeichnet</u>, daß der Signaleingang (E) für das digitale Steuersignal durch das Gate eines ersten Feldeffekttransistors (T1) gegeben und dessen Source mit der Source eines zweiten Feldeffekttransistors (T2) sowie mit dem Drain eines dritten Feldeffekttransistors (T3) verbunden ist, daß dabei der dritte Feldeffekttransistor (T3) an seiner Source durch ein erstes Hilfssignal (AS) gesteuert, der Drain des ersten Feldeffekttransistors (T1) über einen vierten Feldeffekttransistor (T4) sowie der Drain des zweiten Feldeffekttransistors (T2) über einen fünften Feldeffekttransistor (T5) mit je einem der beiden stromführenden Anschlüsse eines sechsten Feldeffekttransistors (T6) verbunden ist, daß außerdem der eine stromführende Anschluß des sechsten Feldeffekttransistors (T6) mit der Source eines siebenten Feldeffekttransistors (T7) und dem Gate eines achten Feldeffekttransistors (T8) und der andere stromführende Anschluß des sechsten Feldeffekttransistors (T6) mit der Source des achten Feldeffekttransistors (T8) und dem Gate des siebenten Feldeffekttransistors (T7) verbunden ist, während der Drain des siebenten Feldeffekttransistors (T7) und der Drain des achten Feldeffekttransistors (T8) über die Reihenschaltung eines neunten Feldeffekttransistors (T9) und eines zehnten Feldeffekttrantransistors (T10) miteinander verbunden sind, daß außerdem die Source des siebenten Feldeffekttransistors (T7) über die Source-Drainstrecke eines elften Feldeffekttransistors (T11) und eines zum elften Feldeffekttransistor (T11) parallel liegenden zwölften Feldeffekttransistors (T12) sowie die Source des achten Feldeffekttransistors (T8) über einen dreizehnten Feldeffekttransistor (T13) und einem zu diesem parallel liegenden vierzehnten Feldeffekttransistor an das erste Versorgungspotential ($V_{cc}$) angeschlossen sind und dabei das Gate des elften Feldeffekttransistors (T11) mit dem Drain des siebenten Feldeffekttransistors (T7) sowie das Gate des dreizehnten Feldeffekttransistors (T13) mit dem Drain des achten Feldeffekttransistors (T8) verbunden ist, daß weiterhin ein Knoten zwischen dem neunten Feldeffekttransistor (T9) und dem zehnten Feldeffekttransistor (T10) über einen fünfzehnten Feldeffekttransistor (T15) mit dem ersten Versorgungspotential ($V_{cc}$) verbunden und das Gate des fünfzehnten Feldeffekttransistors (T15) zusammen mit dem Gate des sechsten Feldeffekttransistors (T6), des neunten Feldeffekttransistors (T9), des zehnten Feldeffekttransistors (T10), des zwölften Feldeffekttransistors (T12) sowie des vierzehnten Feldeffekttransistors (T14) durch ein zweites Hilfssignal (AK) gemeinsam gesteuert ist, während das Gate des zweiten Feldeffekttransistors (T2), des dritten Feldeffekttransistors (T3), des vierten Feldeffekttransistors (T4) und des fünften Feldeffekttransistors (T5) gemeinsam durch ein zwischen den beiden Versorgungspotentialen ($V_{cc}$,$V_{ss}$) liegendes Hilfspotential (UTR) beaufschlagt sind, daß ferner ein sechzehnter Feldeffekttransistor (T16) zusammen mit einem siebzehnten Feldeffekttransistor (T17) zu einem ersten RS-Flip-Flop sowie ein achtzehnter Feldeffekttransistor (T18) zusammen mit einem neunzehnten Feldeffekttransistor (T19) zu einem zweiten RS-Flip-Flop zusammengeschaltet ist, wobei die Sourceanschlüsse der beteiligten Feldeffekttransistoren (T16-T19) am Bezugspotential ($V_{ss}$), während der Drain

des sechzehnten Feldeffekttransistors (T16) mit der Source des siebenten Feldeffekttransistors (T7) sowie der Drain des achtzehnten Feldeffekttransistors (T18) mit der Source des achten Feldeffekttransistors (T8) verbunden ist, während der Drain des siebenzehnten Feldeffekttransistors (T17) mit der Source eines zwanzigsten Feldeffekttransistors (T20) und der Drain des neunzehnten Feldeffekttransistors (T19) mit der Source eines einundzwanzigsten Feldeffekttransistors (T21) verbunden und dabei das Gate des zwanzigsten Feldeffekttransistors (T20) durch den Drain des achten Feldeffekttransistors (T8) sowie das Gate des einundzwanzigsten Feldeffekttransistors (T21) durch den Drain des siebenten Feldeffekttransistors (T7) gesteuert ist, während der Drainanschluß des zwanzigsten Feldeffekttransistors (T20) und des einundzwanzigsten Feldeffekttransistors (T21) an einem dritten Hilfssignal (AP) liegen, und daß schließlich die von einem gemeinsamen Taktgeber (TG) gelieferten Hilfssignale (AS,AK,AP) derart aufeinander abgestimmt sind, daß der Wirkungspegel des ersten Hilfssignals (AS) sowie des zweiten Hilfssignals (AK) praktisch gleichzeitig gegeben und der Wirkungspegel des zweiten Hilfssignals (AS) merklich höher als der Wirkungspegel des ersten Hilfssignals (AS) eingestellt ist, während das etwa denselben Wirkungspegel wie das zweite Hilfssignal (AK) aufweisende dritte Hilfssignal (AP) unmittelbar mit dem Abklingen des ersten Hilfssignals (AS) einsetzt, und daß außerdem der Nullzustand der drei Hilfssignale (AS, AK, AP) durch das Bezugspotential ($V_{ss}$) gegeben und der Sourceanschluß des zwanzigsten sowie des einundzwanzigsten Feldeffekttransistors (T20,T21) als je ein Signalausgang (A1, A2) des Signal-Pegelwandlers verwendet ist.

2.) Adreßpufferschaltung nach Anspruch 1, dadurch gekennzeichnet, daß der durch die Source des zwanzigsten Feldeffekttransistors (T20) gegebene Signalausgang (A1) mit dem Gate eines mit seinem Drain am ersten Versorgungspotential ($V_{cc}$) liegenden weiteren Feldeffekttransistors (t1) und der andere Signalausgang (A2) mit dem Gate eines weiteren Feldeffekttransistors (t2) verbunden ist, dessen Drain ebenfalls am ersten Versorgungspotential ($V_{cc}$) liegt, daß die Sourceanschlüsse dieser beiden Feldeffekttransistoren (t1, t2) je einen Signalausgang (AU1, AU2) des Adreßpuffers bilden und außerdem mit je einem Ausgang eines im übrigen am Bezugspotential ($V_{ss}$) liegenden RS-Flip-Flops (t3, t4) verbunden sind und außerdem über je einen Entladetransistor (t5, t6) ebenfalls mit dem Bezugspotential ($V_{ss}$) verbunden und beide Entladungstransistoren (t5,t6) durch ein gemeinsames viertes Hilfssignal (DV) gesteuert sind.

3.) Signal-Pegelwandler nach Anspruch 1 oder 2, dadurch gekennzeichnet, daß die in der Schaltung verwendeten Feldeffekttransistoren vomselben Typ, insbesondere vom n-Kanal-Anreicherungstyp, sind.

## FIG 1

## FIG 2

## FIG 3

## FIG 4

FIG 4a